# EUROPEAN PATENT APPLICATION

(11) **EP 4 791 180 A1**
(43) Date of publication of application: **12.08.2026**
(21) Application number: 25224172.4
(22) Date of filing: 17.12.2025
(51) Int. Cl.: H10W 70/68, H05K 1/03, H05K 3/46, H10W 40/20, H10W 40/25, H10W 70/685, H10W 74/10

(54) **COMPONENT CARRIER AND METHOD OF MANUFACTURING THE SAME**

(30) Priority: 07.02.2025 CN 202510138110
(71) Applicant: AT & S Austria Technologie & Systemtechnik Aktiengesellschaft, 8700 Leoben-Hinterberg (AT)
(72) Inventor: PARK, Ho Sik, Chongqing, 401120 (CN); DENG, YanChun (YC), Chongqing, 401133 (CN); JIANG, Mingchuan, Chongqing, 401133 (CN); CHEN, Shaoyang, Chongqing, 401133 (CN); CHAN, Joanne, Chongqing, 401121 (CN)
(74) Representative: Donatello, Daniele

(57) **Abstract**

There is described a component carrier (100) having a stack (101), wherein the stack (101) comprises:
i) at least one electrically conductive layer structure (104) and at least one electrically insulating layer structure (102, 140);
ii) an inorganic layer structure (110) with a, in particular planar, main surface (111);
iii) a cavity (120) in the stack (101), defined by a bottom (121) and a sidewall (122); and
iv) at least one stop layer (130), arranged at least partially in or on the main surface (111) of the inorganic layer structure (110) and exposed at the bottom (121) of the cavity (120). The present application further provides a method of manufacturing a component carrier (100).

## Description

### Field of the Invention

The invention relates to a component carrier having a stack, comprising at least one electrically conductive layer structure and at least one electrically insulating layer structure, an inorganic layer structure with a main surface, a cavity in the stack, defined by a bottom and a sidewall, and at least one stop layer, arranged at least partially in or on the main surface of the inorganic layer structure and (exposed) at the bottom of the cavity. Further, the invention relates to a method of manufacturing such a component carrier.

Accordingly, the invention may relate to the technical field of component carriers, such as printed circuit boards or IC substrates, and their manufacture.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. At the same time, component carriers shall be mechanically robust and electrically and magnetically reliable so as to be operable even under harsh conditions.

In particular, forming efficient and reliable stacks with respect to a component carrier, when using an inorganic layer structure, may still be considered a challenge. Such inorganic layer structure have become more and more interesting from a technical and economical point of view. For example, a glass layer structure (glass core) may provide specific advantageous thermal properties. Since glass is not that sensitive to heat, it is not likely to change with heat, therefore there is almost no shrinkage on the glass.

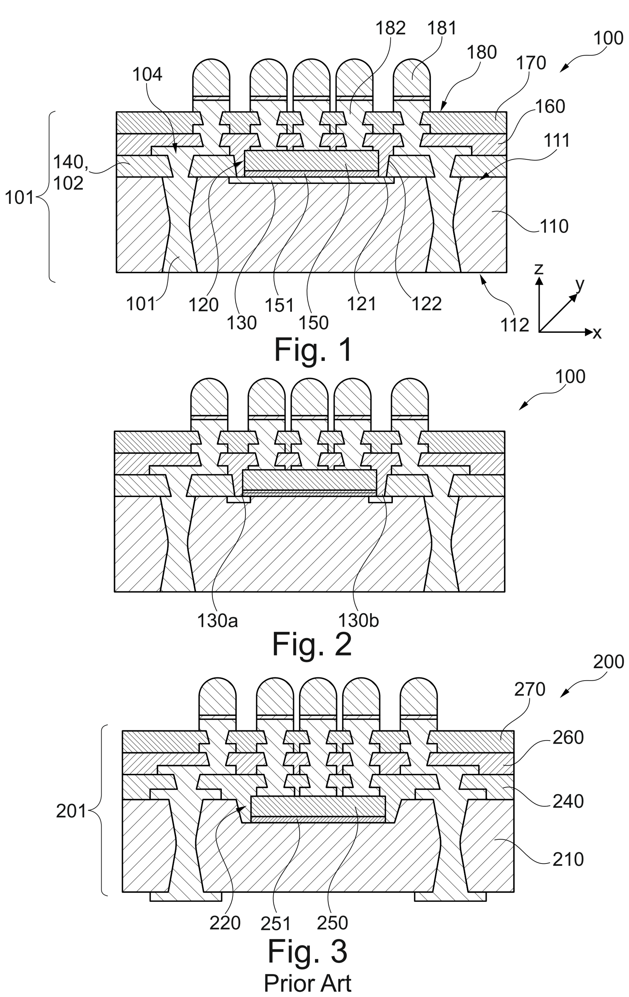

**Figure 3** shows a conventional circuit board 200 with a stack 201 that comprises a glass substrate 210. On top of the glass substrate 210, there are arranged insulating layers 240, 260 and a surface layer 270. A cavity 220 has been formed in the main surface of the glass substrate 210 and a component 250 is arranged on the bottom of the cavity 220 with an adhesive layer 251 in between for stabilization. The insulating layer 240 fills the gaps in the cavity 220 between the sidewalls of the component 250 and the sidewalls of the cavity 220. On the upper main surface of the component 250, there are electrically conductive pads, that are connected by stacked buried vias to the upper main surface of the stack 201. Additional electrically conductive through-connections are formed through the stack 201 laterally to the embedded component 250.

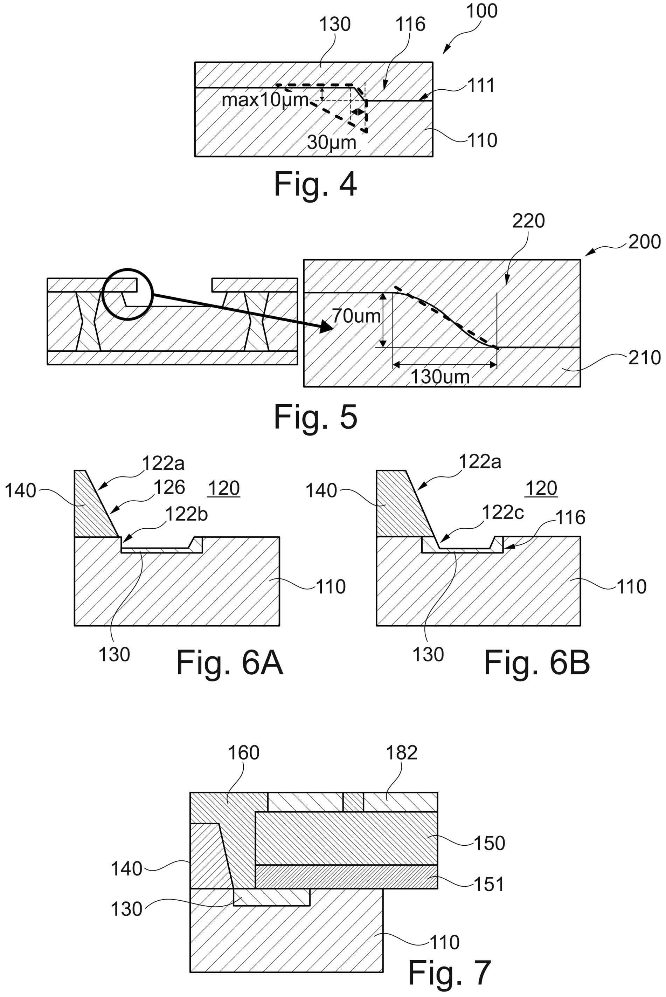

**Figure 5** shows a detailed view of the cavity 220 of such a conventional circuit board 200, wherein the component is embedded in a cavity of the glass substrate. In order to accommodate a component 250, the cavity 220 must have a certain (i.e. large) size, in this example a depth of 70 µm. This leads to a slop length of 130 µm under current technology to form a cavity in the glass. It follows that a lot of glass material has to be removed, leading to higher costs and a risk of damage, e.g. breaking, cracking, etc.

**Figures 14A to 14L** illustrate a conventional manufacture of such a circuit board 200.
Figure 14A: the glass substrate 210 is provided.
Figure 14B: through-holes 205 are formed, e.g. by drilling from above and from below.
Figure 14C: the through-holes 205 are filled with copper by plating.
Figure 14D: remaining copper 236 on the main surface of the glass substrate 210 is removed, e.g. by etching.
Figure 14E: a protective film 245 is formed to prepare cavity formation.
Figure 14F: the cavity 220 is formed, e.g. by drilling (compare Figure 5 described above) in the glass substrate 210.
Figure 14G: the protective film 245 is removed and the cavity 220 is ready.
Figure 14H: electrically conductive pads are formed at the extremities of the through-vias.
Figure 14I: the component 250 is placed in the cavity 220 on top of an adhesive layer 251.
Figure 14J: the component 250 in the cavity 220 is embedded in electrically insulating material 240.
Figure 14K: further layer build-up 282 is done.
Figure 14L: the final circuit board 200 as described for Figure 3 above is provided.

However, these conventional approaches remove a lot of glass material from the glass substrate. Thereby, material may be wasted, while the manufacture is less flexible. Further, there is a high risk of damage (crack, break), when removing glass material from a glass substrate. Thereby, original advantages of the glass substrate may be destroyed and/or get lost.

### Summary of the Invention

There may be a need to provide a component carrier with an inorganic layer structure and an embedded component in an efficient and reliable manner. According to an exemplary embodiment of the invention, a component carrier and a method are described.

According to an aspect of the invention, there is described a component carrier having a (multi-layer) stack, wherein the stack comprises:
i) at least one electrically conductive layer structure (e.g. a copper layer) and at least one electrically insulating layer structure (e.g. a resin layer);
ii) an inorganic layer structure (in particular a glass layer) with a, in particular planar, main surface;
iii) a cavity (e.g. in one electrically insulating layer structure) in the stack, defined (in the shape) by a bottom and a sidewall; and
iv) at least one stop layer (e.g. a metal layer, in particular a seed layer), arranged at least partially in or on the main surface of the inorganic layer structure and (exposed) at the bottom of the cavity.

According to a further aspect of the invention, there is described a method of manufacturing a component carrier, the method comprising:
i) providing an inorganic layer structure with a main surface,
ii) arranging at least one stop layer at least partially in or on the main surface of the inorganic layer structure,
iii) forming an electrically insulating layer structure and an electrically conductive layer structure on said main surface of the inorganic layer structure to provide a stack, and
iv) forming a cavity in the stack, defined by a bottom and a sidewall, wherein the stop layer is arranged at the bottom of the cavity.

In the context of the present document, the term "component carrier" may particularly denote any support structure which is capable of accommodating one or more components thereon and/or therein for providing mechanical support and/or electrical connectivity and/or thermal connectivity. In other words, a component carrier may be configured as a mechanical and/or electronic or thermal carrier for components. In particular, a component carrier may be one of a printed circuit board (PCB), an organic interposer, and an integrated circuit (IC) substrate. A component carrier may also be a hybrid board combining different ones of the above-mentioned types of component carriers.

In the context of the present application, the term "stack" may particularly denote a flat or planar sheet-like body. For instance, the stack may be a layer stack, in particular a laminated or rolled layer stack. Such a laminate may be formed by connecting a plurality of layer structures by the application of mechanical pressure and/or heat. Preferably, the plurality of layer structures are aligned parallel on top of each other. The stack may comprise electrically conductive structures and at least one electrically insulating structure.

In the context of the present application, the term "layer structure" may particularly denote a continuous layer, a patterned layer or a plurality of nonconsecutive islands (discontinuous) within a common plane, and it may perform the function of electrical conductivity and/or electrical insulation. A layer structure may also comprise an interconnection structure which protrudes from a planar surface of the layer structure.

In this context, the term "inorganic layer structure" may in particular refer to a layer structure that comprises or consists of an inorganic material. An inorganic layer structure may be part of a stack of a component carrier. Inorganic materials can for example include ceramics, glass, metals, or other non-organic substances, in particular do not contain carbon-hydrogen bonds. In an example, the inorganic layer structure has a main surface that is particularly planar, meaning it is flat and even. This planar surface may be for providing a stable and uniform base for other layers and components in the stack. The use of inorganic materials in this layer may offer an improved thermal stability, mechanical strength, and resistance to environmental factors compared to organic materials.

In an example, the inorganic carrier layer may comprise a semiconductor material, for example silicon and/or germanium and/or silicon oxide and/or germanium oxide and/or silicon carbide and/or gallium nitride. In a further embodiment, the inorganic layer structure may comprise (in particular elemental) metal and/or one or more metal alloys, for example, copper and/or tin and/or brass. Yet in another embodiment, the inorganic layer structure may comprise inorganic material, which is not listed in the above mentioned examples, such as: MoS₂, CuGaO₂, AgAlO₂, LiGaTe₂, AgInSe₂, CuFeS₂, BeO.

In this context, a "stop layer" may refer to a specific layer within the component carrier stack structure, in particular formed in or on the inorganic layer structure. Preferably, the stop layer may be formed in a recess in the main surface of the inorganic layer structure. The stop layer may serve to limit or stop a material removal processes (e.g. etching or drilling) during the formation of a cavity. The presence of the stop layer may thus ensure precise control over the depth and dimensions of the cavity, thereby enhancing the accuracy and reliability of the manufacturing process. The stop layer may be further advantageous in maintaining the structural integrity of the component carrier and preventing over-removal, which could otherwise lead to defects or damage on other layers. The stop layer may comprise one or more layers. In an embodiment, the stop layer comprises a metal, e.g. copper, nickel, tungsten, silver, gold or titanium and copper or another metal that improves the adhesion between the inorganic material and copper. The stop layer may at least partially be removed in some situations. The stop layer may comprise a none metal material. In an example, the stop layer is thinner than other electrically conductive layers of the stack, e.g. configured as a seed layer.

In this context, "cavity" may refer to a hollow space or void within the stack of the component carrier. This cavity may be defined by a bottom surface and a sidewall, and may be formed within the stack that comprises at least one electrically conductive layer structure and at least one electrically insulating layer structure and/or the inorganic layer structure. The cavity is designed to accommodate at least one component. The presence of the cavity may thus allow for the embedding of components, such as dies, within the stack, providing a compact and efficient design. In an embodiment, the cavity may be delimited/defined by the bottom and the sidewall(s). Preferably, at least a part of the sidewall(s) of the cavity and/or at least part of the bottom of the cavity may be composed of the inorganic layer structure. In an embodiment, the recess (with the stop layer) is part of the cavity. In another embodiment, the stop layer (the recess) may delimit/define the bottom of the cavity.

According to an exemplary embodiment, the invention may be based on the idea that a component carrier with an inorganic layer structure and an embedded component can be provided in an efficient and reliable manner, when the component is embedded in a cavity in an electrically insulating layer structure of the stack, wherein, at the bottom of the cavity, there is exposed a stop layer on/in the main surface of the inorganic layer structure. In other words, instead of the component itself, only a thin stop layer is actually embedded in the inorganic layer structure. The component is embedded in a cavity formed on top of the stop layer and the inorganic layer structure.

In this manner, a precise and reliable embedding of the component in the component carrier stack can be enabled, while maintaining the structural integrity and inherent properties of the inorganic layer structure. The invention may minimize the amount of inorganic material (in particular glass) removed during cavity formation, which reduces the risk of cracks and breakage during processing, and also provides a more straight cavity sidewall. This approach may also allow for maintaining high (Young's) modulus, low warpage, and low crack risk, which may be crucial for the durability and performance of the component carrier.

Further advantages may include increased design flexibility, e.g. due to a narrow cavity slope, which allows for a reduced margin between the component and an electric connection. This may result in a more compact and efficient design. The reduced cavity area may help in maintaining the structural properties of the inorganic material. Efficient and well-established methods may be used during the manufacture, e.g. build-up layer cavity, ensuring compatibility with existing high-volume manufacturing processes.

The advantages of this configuration may further include the ability to precisely control the formation of cavities within the stack, which can be beneficial for embedding components. The stop layer may help in defining the depth and boundaries of the cavity, ensuring accurate and consistent cavity formation.

### Detailed Description of Exemplary Embodiments

In the following, further exemplary embodiments of the component carrier and the method will be explained.

In an embodiment, the stop layer is (at least partially) embedded in a recess of the inorganic layer structure (in particular the upper main surface of the stop layer is flush with the top of the recess). In an embodiment, the recess comprises a height of 10 µm or less. This embedding within a recess may ensure that the stop layer is securely positioned and protected, potentially reducing the risk of displacement or damage during the manufacturing process or in operational environments. The recess may provide a precise and controlled space for the stop layer, ensuring minimal deviation and maintaining the integrity of the main surface of the inorganic layer structure. Preferably, the recess has a height of 10 µm or lower, in particular 5 µm or lower; in other words, the recess (and the respective stop layer) is very thin. Conventional cavities in a glass substrate (compare Figure 5) comprise a much larger thickness, e.g. 70 mm or larger. Further, the amount of inorganic material (in particular glass) removed during cavity/recess formation may reduce the risk of cracks and breakage during processing and/or save material (costs).

In an embodiment, the stop layer is configured as a metal layer and/or an electrically conductive structure. This may provide the advantage that the stop layer can be provided in a straightforward manner using established component carrier manufacture techniques (i.e. in the same manufacture process). In an embodiment, the stop layer comprises/consist of a copper layer and/or a titanium layer. Such a layer may be provided by an established sputtering process and/or e-less plating process. In an embodiment, such a Cu/Ti layer is applied as a (very thin) seed layer. In an embodiment, the stop layer can serve not only as a physical barrier and stabilization structure, but also as an electrical pathway, which could be advantageous for the functionality of the component carrier. Copper is widely used in the electronics industry due to its high electrical conductivity, while titanium is known for its strength and resistance to corrosion, or as well as an adhesion promotion for copper layer and inorganic material such as glass.

In an embodiment, the stop layer is a single layer or a multiple layer (e.g. Cu/Ti). In an embodiment, the thickness of the single layer or one of the multiple layers is smaller than that of the (other) electrically conductive layer structure(s) of the stack. In an embodiment, the stop layer is a seed layer. In an embodiment, only a part of a seed layer is configured as the stop layer. In an embodiment, the seed layer comprises titanium and/or copper or other metal or other inorganic coating or sputtering layer. Thereby, the adhesion between the inorganic material and metal/copper may be improved. A "seed layer" is typically used to promote the growth of another layer (in particular by plating), usually a conductive layer, on its surface.

In an embodiment, the stop layer is a continuous layer. In an embodiment, the stop layer covers the entire bottom of the cavity or covers the four sidewall areas of the cavity. In another embodiment, the stop layer is a discontinuous layer. In an embodiment, the stop layer may include at least two isolated stop layer portions. When the stop layer is composed of a continuous layer, manufacturing of the component carrier may be simplified, since fewer process steps are required. When the stop layer is composed of a discontinuous layer, material can be saved, for example copper. Additionally, with the options of different design, it does not only provide the function of stop layer for cavity formation in the inorganic layer structure, but also provides the flexibility of the stop layer design aligned with the whole component carrier design based on required application fulfilling different functions under variable situation.

In an embodiment, at least a part of one main surface of the stop layer is flat and/or comprises a low roughness. Preferably, the main surface may be opposed to the bottom of the cavity. This may ensure that the stop layer has a reliable mechanical and/or electrical contact with a component.

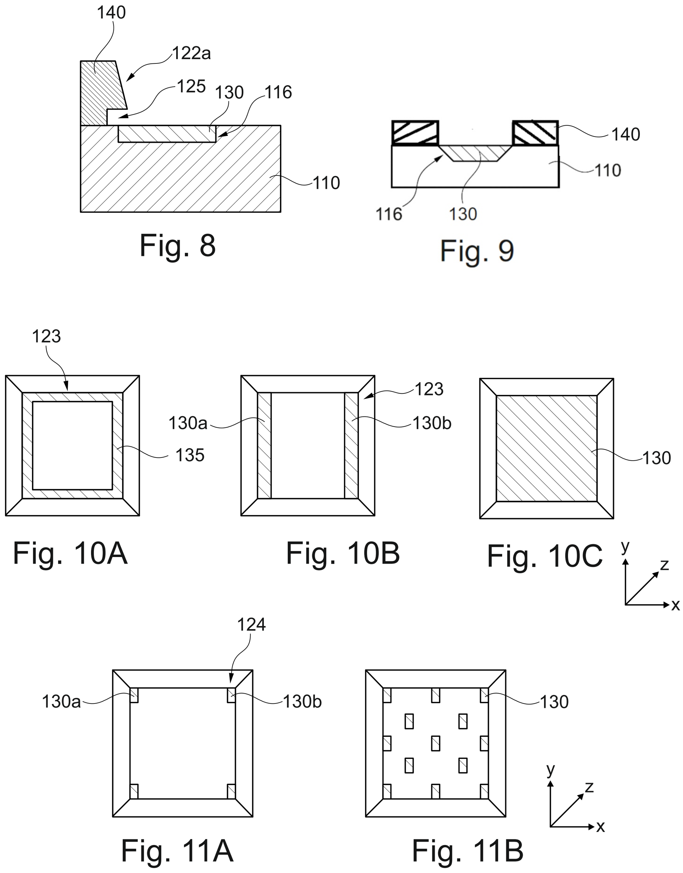

In an embodiment, the at least two stop layer portions cover two or more edge portions (in particular corners) of the bottom of the cavity (compare Figure 11A). The component may be placed in a reliable manner, yet requires only a small amount of stop layer material (and very small recesses). In an embodiment, the at least two stop layer portions cover only the (whole) edge portion(s) of the cavity. This design can bring an advantage of removing very little inorganic material on the surface of the inorganic layer structure, so that the risk of crack or damage of the inorganic layer structure may be minimized. Further, the size of the stop layer made of metal may be minimized, thus the dielectric layer, which will be more directly laminated on the surface of inorganic layer structure surface, may serve as a buffer layer between the inorganic layer structure and further metal layer(s) in the build-up layer of a redistribution layer instead of the whole seed layer deposited on the inorganic layer structure.

In an embodiment, the at least two stop layer portions cover two or more side (edge) portions of the bottom of the cavity (compare Figure 10B). The component may be placed reliably and efficiently on these lateral stop layer portions. With such kind of design, a higher tolerance may be provided for the cavity formation to guarantee the portion of the cavity in the inorganic layer structure to align with the portion of cavity in the other layers.

In an embodiment, the at least two stop layer portions are distributed over the bottom of the cavity (homogenously or inhomogenously) (compare Figure 11B). In this manner, a flexible design is enabled and/or each stop layer may serve for an individual component connection/stabilization. In an example, the stop layer distribution may serve as an interconnection structure with the component. Beside that it can also provide a function of heat dissipation.

In an embodiment, the at least two stop layer portions are configured as a frame-type electrically conductive structure that is connected or connectable to ground (compare Figure 10A). In an example, the/all (four) side portions and the/all (four) edge portions may be covered by the stop layer, thereby forming a frame-type structure. Configuring the stop layer as a frame-type electrically conductive structure connected to ground can enhance the grounding capabilities of the component carrier, thereby improving its overall electrical performance and stability. Further, a ground-connected frame may be used to detect an electric contact, e.g. with a routing bit, thereby fulfilling a stop functionality.

In an embodiment, the stop layer can be a full metal layer totally covering the cavity bottom (compare Figure 10C). The two kinds of designs may have high tolerance, manufacturing a metal stop layer by plating with an easier control since the frame is a continuous pattern. Except that, the frame can also bring a benefit of cavity formation when using laser drilling in glass material. Since glass is transparent, the laser energy may transmit from one surface to the other opposite surface and result in the damage of the other surface by the heat from laser. Therefore, the frame at the whole edge of the cavity as stop layer can resist the laser ablation and then, the laser ablation will be absorbed by the frame without transmission of the whole glass core.

These configurations may provide various mechanisms for the stop layer to interact with the cavity and the inorganic layer structure. The continuous layer may ensure uniform coverage and potentially enhances the structural integrity and electrical properties of the component carrier and also prevent the laser light from going through the whole glass layer structure to cause the damage of the other side. In contrast, the discontinuous layer may allow for more flexibility in design, enabling specific areas of the cavity to be targeted for coverage. The isolated stop layer portions can be strategically placed to reinforce certain parts of the cavity or to provide specific electrical pathways. Covering the edge portions of the cavity can help in preventing material degradation or electrical interference at these critical points. Distributing the stop layer portions over the bottom of the cavity can optimize the overall performance of the component carrier.

In an embodiment, the stop layer includes a protruding portion that defines a part of the cavity sidewall and/or protrudes from a further, in particular planar, portion of the stop layer. In an embodiment, the stop layer is electrically connected or connectable with at least one electrically conductive layer structure of the stack, particularly through electrically conductive through connections. Thereby, a variety of electric connections/functionalities may be provided in a flexible manner. It may also partially prevent the damage of the other material of the sidewall resulting from the laser ablation reflecting to sidewall, since the protruding portion stop layer covering part of the sidewall can absorb the energy from the laser to avoid the laser ablation totally reaching the other material of the sidewall.

In an embodiment, the stop layer is connected with the inorganic layer structure at the same level on the main surface and extends beyond the bottom of the cavity in a horizontal direction. This extension can provide additional surface area for bonding or connection purposes, potentially enhancing the mechanical anchoring of the stop layer within the cavity and improving the overall stability and durability of the component carrier. Besides that, when the stop layer is configured as an electrically conductive pattern, the stop layer can directly connect with the electrically conductive structure on the surface of the inorganic layer structure at same level, which shortens the signal path.

In an embodiment, the component carrier includes a component arranged at least partially in the cavity and at least partially on, in particular directly on, the stop layer. In an example, the component is directly placed on the stop layer, while in another example, an adhesion layer is arranged between component and stop layer. In an embodiment, the component may be (electrically) connected to the stop layer. The component may have a smaller, equal (flush), or larger height/thickness as the cavity. That means the cavity is mainly formed in the dielectric layer instead of the inorganic layer structure. Therefore, the cavity can be formed by minimizing the risk of damage the inorganic layer structure and meanwhile realizing the embedding function in the component carrier with the inorganic layer structure. Eventually, the integrated package with fine line structure can be resolved without crack issue.

In an embodiment, the component is at least partially encapsulated in electrically insulating material (e.g. an encapsulation/molding material such as (uncured) resin). The encapsulation of the component in electrically insulating material may imply a protective mechanism that isolates the component electrically, ensuring that it is insulated from other conductive elements within the stack. This encapsulation could also provide mechanical stability and protection from environmental factors.

In an embodiment, the component is coupled at the bottom of the cavity by an adhesion portion, in particular an adhesive layer, provided on the bottom of the cavity (or provided on the bottom of component), in particular covering the bottom of the cavity and/or adhering to at least a part of the sidewall of the cavity. In an embodiment, the component is coupled at the bottom of the cavity by sintering on the stop layer. The coupling of component and cavity bottom (stop layer) may be achieved through an adhesion portion, which may be an adhesive layer provided on the bottom of the cavity. This adhesive layer is particularly noted for its ability to cover the bottom of the cavity and/or adhere to at least a part of the sidewall of the cavity. Alternatively, the coupling can be achieved through a sintering process on the stop layer. Thereby, it may be ensured that the component is firmly coupled at the bottom of the cavity. This may enhance the reliability and stability of the component carrier by providing specific techniques for component attachment.

In an embodiment, the component carrier further includes an encapsulation layer structure (in particular an electrically insulating layer structure) that is in contact with at least one of the component, in particular the lateral side and/or top side, the sidewall of the cavity, the bottom of the cavity, the adhesion portion, the stop layer, and the inorganic layer structure. In an embodiment, the encapsulation layer structure defines the layer structure on top of the main surface of the inorganic layer structure. The encapsulation layer structure may serve to protect the component, potentially enhancing the durability and reliability of the component carrier. When being in contact with multiple parts of the component carrier, the encapsulation layer structure may ensure a more robust and reliable connection between the various components. This feature may also facilitate better management of thermal and mechanical stresses within the component carrier, thereby enhancing its overall reliability.

In an embodiment, the component carrier further includes an electrically insulating layer, in particular an electrically insulating layer structure of the stack, arranged on the inorganic layer structure, wherein the cavity is at least partially formed in the electrically insulating layer. In an embodiment, the cavity extends in the electrically insulating layer above the main surface of the inorganic layer structure. In an example, the electrically insulating layer structure is not only configured as a layer to accommodate the component, but also as a buffer layer between the inorganic layer structure and the electrically conductive layer of an RDL or build up layer of the component carrier to improve the adhesion between the inorganic material and the metal layer above. In an embodiment, the encapsulation layer structure is arranged at least partially on the electrically insulating layer. This may provide the advantage that the cavity can be formed in a straightforward and reliable manner, e.g. by drilling/etching. The stop layer may hereby serve as an efficient element to control the cavity formation process/depth. arrangement may facilitate the formation of the cavity at least partially within the electrically insulating layer. This may provide a more precise and controlled formation of the cavity, e.g. compared to drilling into a glass substrate. In an example, the bottom of the cavity may be free from the material of the electrically insulating layer.

In an embodiment, the component carrier further includes a redistribution layer (RDL) structure arranged on the inorganic layer structure and/or on the component. In an embodiment, the redistribution layer structure facilitates electrical connections and pathways within the component carrier, enhancing its functionality and integration capabilities. For example, the RDL structure may translate small pads (small pitch) of the embedded component to large pads (large pitch) at the external surface of the stack, e.g. solder balls. In an example, the RDL structure may be realized with vertically stacked vias and/or electric connections (pads). Such an RDL structure may be manufactured using an established build-up process starting from the inorganic layer structure, the electrically insulating layer and/or the component, and the RDL can be formed with high density and fine line structure with the supporting of inorganic layer structure. In an example, the redistribution structure may comprise at least two electrically insulating layer structures.

In an embodiment, the cavity extends towards one main surface of the outermost layer of the stack. In an embodiment, the cavity extends vertically over a plurality of layer structures or exclusively one layer structure, in particular only one electrically insulating layer structure, of the stack. By extending the cavity towards the main surface of the outermost layer of the stack, the design may facilitate easier access to the cavity for subsequent processing steps, such as the insertion of components or the application of coatings. The ability to extend the cavity over multiple layer structures may enable more complex and multifunctional designs, as different layers can be tailored to provide distinct electrical, thermal, or mechanical characteristics, in particular the RDL structure. With the invention, a deeper cavity formation may be realistic in a component carrier with inorganic layer structure by forming the cavity in one or more layer structure based on the requirement.

In an embodiment, the insulating layer above the inorganic layer structure surface may have higher thickness compared with other insulating layer structure in the RDL, thus the deeper cavity can be formed in one layer. In an embodiment, the insulating layer above the inorganic layer structure may be formed by a photosensitive dielectric material, thus the cavity can be formed by exposure or excimer laser with more efficiency.

In an embodiment, the sidewall is defined by the electrically insulating layer exclusively. In an embodiment, the sidewall is defined by the electrically insulating layer and the inorganic layer structure. In an embodiment, the sidewall is (at least partially) defined by the electrically insulating layer. In an embodiment, the sidewall is (at least partially) defined by the stop layer. These different embodiments with respect to sidewall definition may allow for tailored solutions to meet specific application requirements, offering flexibility in design and optimization of the component carrier performance characteristics. The flexible design can provide the tolerance in the manufacturing for the cavity formation.

In an embodiment, the cavity comprises at least two sidewall portions (e.g. connected in the vertical direction/extension). In an embodiment, a first sidewall portion is formed in the electrically insulating layer structure. In an embodiment, a second sidewall portion is formed in the electrically conductive layer structure or in particular by the stop layer (compare e.g. Figure 6B). In a first example, the sidewall of the cavity may be formed exclusively by the electrically insulating layer. In a second example, the sidewall of the cavity may be formed by said electrically insulating layer and by a part of the stop layer. In the latter case, the cavity may extend into the recess (and/or the stop layer may not fully fill the recess). Such embodiments may be advantageous for specific applications and provide a flexibility for design and tolerance for manufacturing.

In an embodiment, a third sidewall portion is formed by the inorganic layer structure (see for example Figure 6A). In an example, a top surface, an edge, or a sidewall in the recess of the inorganic layer structure may serve as a third sidewall portion of the cavity, in particular in case that the recess is not completely filled by the stop layer. This may provide an option of making the recess can larger in the inorganic layer structure based on the application.

In an embodiment, the first sidewall portion and/or the third sidewall portion is recessed by a recessed portion (indentation) with respect to a vertical direction (see e.g. Figure 8). This may provide a very good alignment for the different portions of cavity. In an embodiment, at least a part of the recessed portion is arranged in parallel to the bottom of the cavity. In an embodiment, the recessed portion is at least partially filled with material of the encapsulation layer structure. In an embodiment, the encapsulation material is in contact with at least a part of the sidewall that defines the recessed portion. Such a recessed portion may provide a cavity, for example in the vertical direction between a protrusion of the electrically insulating layer and the inorganic layer structure. This embodiment may provide the advantage that encapsulation material may enter the recessed portion, thereby providing a stable and reliable embedding. The component can be delimited in the tight area and the encapsulation material can firmly fix the component in the recess, thus the alignment of the component with the structure of component carrier may be controlled and be more reliable

In an embodiment, the first sidewall portion and the second sidewall portion and/or the third sidewall portion have a different slope. Thereby, a variation in the geometric design may be provided to optimize the cavity for specific applications, potentially improving the performance and efficiency of the component carrier. These differences may reflect different manufacture processes, e.g. forming the cavity in the electrically insulating layer and forming the recess in the inorganic layer structure (for example by different processes, and or different geometries). This design may provide a higher tolerance in manufacturing and reduces the difficulty of manufacturing.

In an embodiment, the cavity extends through the stop layer. In an embodiment, at least a part of the sidewall and/or the bottom of the cavity is defined by the stop layer. Depending on the embodiment, the stop layer may form a part of the cavity. While in one example, the stop layer may form the bottom of the cavity, in another example the stop layer may at least partially extend into the cavity. In a further example, in particular when the recess is not fully filled with the stop layer, the cavity may extend into the recess. By having the cavity extend through the stop layer, the structural integrity and precision of the cavity may be enhanced, as the stop layer can provide a well-defined and stable boundary. Additionally, the stop layer defining at least a part of the sidewall and/or the bottom of the cavity may contribute to improved material properties, such as increased resistance to wear or chemical stability, depending on the material composition of the stop layer.

In an embodiment, the cavity is provided in at least two different electrically insulating materials. Preferably, the at least two different electrically insulating materials may be composed of respective electrically insulating layer structures. Additionally or alternatively, the at least two different electrically insulating materials may be free from ceramic material. In an example, the one of the at least two electrically insulating materials may comprise polymeric organic material, for example, epoxy resin, whereas the other of the at least two electrically insulating materials may comprise glass. This may bring the advantage of combining and/or imparting physical and/or mechanical properties, for example Young's modulus and/or surface energy to the component carrier and thus enabling a manufacturing of a component carrier with high quality.

In an embodiment, the other main surface of the inorganic layer structure is free from being disrupted by a cavity and/or is free from contact with an electrically insulating layer structure.

In an embodiment, the cavity is formed by drilling/etching. In an embodiment, the stop layer is an etch/drill stop layer. In an embodiment, the stop layer is configured to (trigger) stop the drilling/etching process. With the invention, the cavity can be formed by drilling/etching in the component carrier with inorganic layer structure in an easier manner compared with the cavity purely formed in the inorganic layer structure. In an embodiment, the stop layer is configured to define the depth of the cavity.

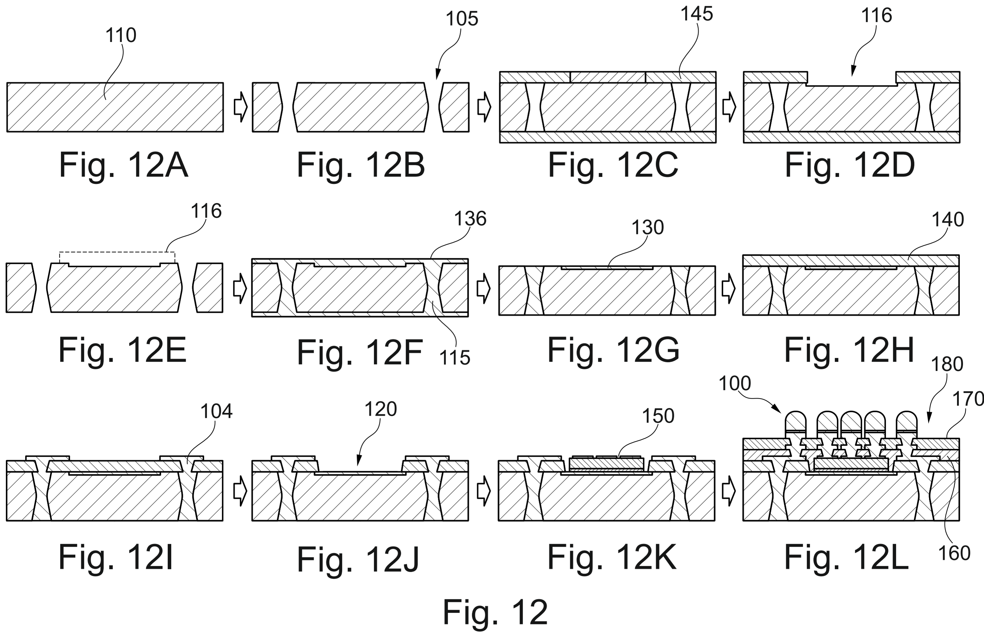

In an embodiment, the stop layer may comprise a (high) roughness, in particular at the edge area between the sidewalls and bottom wall. In an embodiment, the sidewall of cavity may also comprise some roughness. **In** an embodiment, the stop layer may comprise an undercut. These structural features may be formed e.g. by a laser drilling process at the edge area (compare e.g. Figure 12J).

In an embodiment, the height of the sidewall of the cavity, in particular the recess in the inorganic layer structure, is larger than the thickness of the electrically conductive layer structure of the stack. In an embodiment, the height of the sidewall of the cavity, in particular the recess in the inorganic layer structure, is in the range of 0.5 to 2 times larger. In an embodiment, the height of the sidewall of the cavity, in particular the recess in the inorganic layer structure, is 10 µm or less. This may ensure that the cavity is sufficiently deep to accommodate various components or materials that need to be embedded within the cavity, potentially improving the functionality and versatility of the component carrier.

In an embodiment, a sidewall of the recess in the inorganic layer structure comprises a slope width of 40 µm or less, in particular 30 µm or less, in particular 25 µm or less. In an embodiment, the sidewall of the recess in the inorganic layer structure is (essentially) straight and/or linear, e.g. not curved. This may provide the advantage that less inorganic material has to be removed, thereby saving costs and efforts, and reducing the risk of material damage. Further, the recess may be efficiently adapted to current requirements. In an embodiment, the sidewall of the recess can be substantially straight with good alignment with the insulating layer structure of the RDL, since the small recess can be formed with a straight sidewall and the cavity area in the insulating layer can be formed in a straight manner. As long as the alignment is guaranteed, the substantially straight sidewall may be realistic.

In an embodiment, the component carrier further comprises a stepped region at an interface of the electrically insulating layer and the inorganic layer structure (see e.g. Figure 6A). Such a stepped portion may be provided for example by an edge of the inorganic layer structure, in particular when not fully covered by the electrically insulating layer. The stepped region may enhance the mechanical stability of the component carrier by providing a more robust connection between the electrically insulating layer and the inorganic layer structure. This stepped region may also facilitate a higher tolerance for alignment and positioning of the layers during the manufacturing process. The presence of the stepped region at the interface may also aid in the distribution of mechanical stresses, thereby enhancing the overall durability and reliability. In an embodiment, the stepped portion may be within the misalignment tolerance. In an embodiment, the stepped portion is totally aligned at the interface and/or with different taper for the insulating layer and inorganic layer.

In an embodiment, forming the cavity (and/or the recess) comprises drilling, in particular laser drilling or mechanical drilling (e.g. routing or grinding). In an embodiment, laser drilling may be done using a CO₂ laser or Pico laser. In an embodiment, stopping the cavity formation is based on an effect caused by the stop layer, in particular a laser drilling stop or formation of an electric contact. In an example, a CO₂ laser may stop at a metal/copper layer, so that the stop layer may be efficiently and precisely used to control the drilling process. In a further example, the stop layer may be electrically connected in such a manner that an electric contact of a mechanical drill (e.g. a routing bit) with the stop layer may indicate and/or stop the drilling process. Also in this case, the stop layer may be efficiently and precisely used to control the drilling process. In another example, the cavity may be formed by etching and the stop layer may be formed as an etch-resistant layer.

In an embodiment, the method further comprises placing a component in the cavity and on the stop layer, in particular directly on the stop layer or with an adhesion layer in between. In an embodiment, the method further comprises encapsulating, in particular by lamination, the component in the cavity. In an embodiment, the method further comprises forming a redistribution layer structure on top of the inorganic layer structure and/or the component. These features (see also details above) may provide for an efficient embedding process.

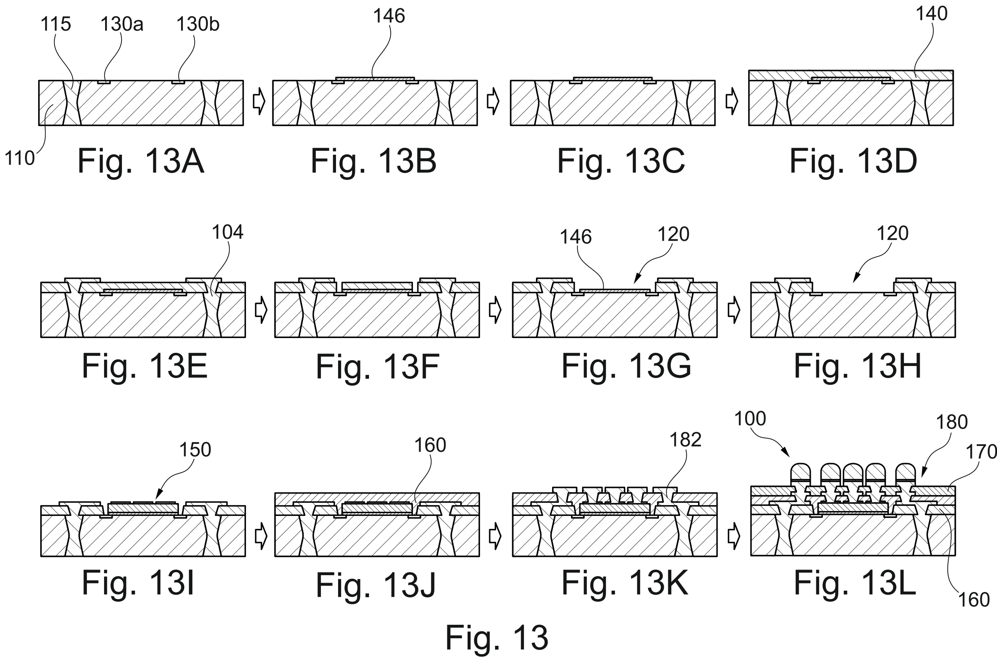

In an embodiment, the method further comprises providing a temporary structure, in particular printed ink, on the stop layer, and in particular on the inorganic layer structure and between a first portion of the stop layer and a second portion of the stop layer. Such a temporary structure may be especially efficient for forming a discontinuous stop layer, e.g. two or more isolated stop layer portions (see for example Figures 13A to 13L). The temporary structure may be configured as a release layer, so that a part of the electrically insulating layer (the part on top of the temporary structure) can be removed in a straightforward manner. Thereby, a cavity with two or more isolated stop layer portions at the bottom can be provided in a precise manner.

In an embodiment, the method further comprises removing a part of the main surface of the inorganic layer structure, in particular by drilling and/or etching (e.g. etching or laser plus etching), to provide a recess. In an embodiment, the method comprises arranging the stop layer at least partially in the recess, in particular by sputtering (as a seed layer) and/or by plating. This may provide the advantage that efficient and established component carrier manufacture techniques can be directly applied for forming the recess and/or the stop layer.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board.

A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, titanium and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component (in particular the embedded component), which may be surface mounted on and/or embedded in the component carrier, can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of an component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.

### Brief Description of the Drawings

Figure 1 illustrates a component carrier with a continuous stop layer according to an exemplary embodiment of the invention.
Figure 2 illustrates a component carrier with a discontinuous stop layer according to an exemplary embodiment of the invention.
Figure 3 illustrates a conventional circuit board.
Figure 4 shows a detailed view of the cavity, according to an exemplary embodiment of the invention.
Figure 5 shows in detail a conventional cavity.
Figures 6A, 6B, 7, and 8 respectively show details of component carriers according to exemplary embodiments of the invention.
Figures 9, 10A, 10B, 10C, 11A, and 11B respectively show a stop layer configuration, according to exemplary embodiments of the invention.
Figures 12A to 12L show a method of manufacturing a component carrier with a continuous stop layer, according to an exemplary embodiment of the invention.
Figures 13A to 13L show a method of manufacturing a component carrier with a discontinuous stop layer, according to an exemplary embodiment of the invention.

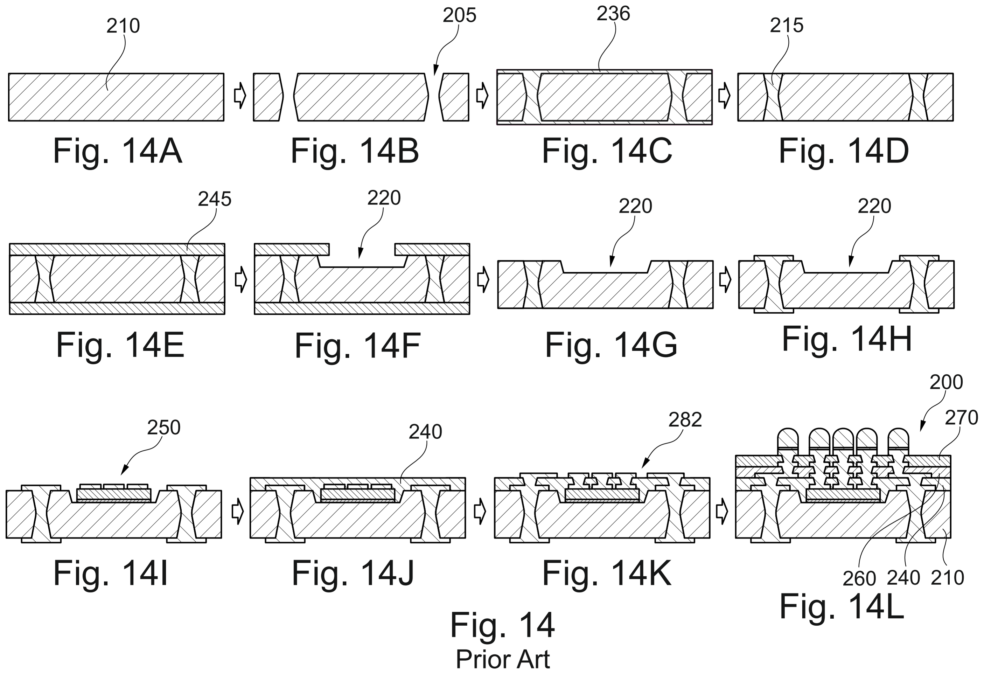

Figures 14A to 14L show a conventional manufacture process.

### Detailed Description of the Drawings

**Figure 1** illustrates a component carrier 100, according to an exemplary embodiment of the invention, having a stack 101 with at least one electrically conductive layer structure 104 and at least one electrically insulating layer structure 102, 140. An inorganic layer structure 110 with a planar main surface 111 is also part of the stack 101. A cavity 120 is defined in the stack 101 by a bottom 121 and a sidewall 122. At least one stop layer 130 is arranged at least partially in or on the main surface 111 of the inorganic layer structure 110 and exposed at the bottom 121 of the cavity 120.

The stop layer 130 is embedded in a recess 116 of the inorganic layer structure 110, with the recess 116 having for example a height of 10 µm or less. In an example, the recess 116 may have a height in the range from 0.1 µm to 10 µm.

The stop layer 130 is configured in this example as a metal layer, specifically a copper layer or copper and titanium layer. The stop layer 130 is in this example further a continuous single layer with a thickness smaller than that of the electrically conductive layer structure 104 of the stack 101, e.g. configured like a seed layer. The stop layer 130 covers as a continuous layer the entire bottom 121 of the cavity 120. The cavity 120 is formed in the electrically insulating layer structure 102, 140. While in one example, the recess 116 can be understood as part of said cavity 120, in another example, the cavity 120 may be defined only within the electrically insulating layer structure 102, 140.

A component 150 (e.g. an active or passive component) is arranged at least partially in the cavity 120 and directly on the stop layer 130. Alternatively, at least two components 150 may be arranged at least partially in the cavity 120 and directly on the stop layer 130. The component 150 is further encapsulated in electrically insulating material from the electrically insulating layer 102, 140 and an encapsulation layer structure 160.

**In** an example, the electrically insulating layer structure 102, 140 and the encapsulation layer structure 160 may comprise organic polymeric material, for example epoxy resins. Preferably, the encapsulation layer structures 160 may be free from glass fibres, whereas the electrically insulating layer structure 102, 140 may comprise glass fibres. The component 150 is coupled at the bottom 121 of the cavity 120 by an adhesion portion 151, specifically an adhesive layer covering (partially) the bottom 121 of the cavity 120.

In an example, the adhesion portion 151 may be attached at the component 150 and provided together with the component 150 into the cavity 120. Alternatively, the adhesion portion 151 may be applied by a 3-D printing process and/or a dispensing process. The adhesion portion 151 may comprise organic adhesive material, for example a glue.

The material of the encapsulation layer structure 160 is in contact with the component 150 (sidewalls and top wall), the sidewall 122 of the cavity 120, the bottom 121 of the cavity 120, the adhesion portion 151, and the stop layer 130.

An electrically insulating layer 140 is arranged on the inorganic layer structure 110, with the cavity 120 at least partially formed in said electrically insulating layer 140. The cavity 120 extends in the electrically insulating layer 140 above the main surface 111 of the inorganic layer structure 110. The encapsulation layer structure 160 defines the layer structure on top of the electrically insulating layer 140 regarding thickness direction Z. In other words, the electrically insulating layer structure 140 may be arranged between the encapsulation layer structure 160 and the inorganic layer structure 110.

On top of the encapsulation layer structure 160, there is arranged a surface layer 170 (e.g. a solder resist and/or a surface finish). A redistribution layer structure 180 is formed in the encapsulation layer structure 160 and the surface layer 170. In this example, the redistribution layer structure 180 is realized by electric via connections 182, specifically stacked buried vias. Electrically conductive layer structures 104 are hereby arranged between the electrically insulating layer structures 102. The via connections 182 are in this example vertically connecting said respective electrically conductive layer structures 104. In this manner, electric contacts on top of the embedded component 150 can be electrically connected to through the via connections 182 to electric connections (here solder balls) on top of the stack 101 (external surface). The electrical connection or wiring of the component 150 is thus further distributed through the RDL 180 by vias 182 connecting the component 150. Furthermore, electric through-connections 115 (through-vias) extend through the inorganic layer structure 110 are further connected to said redistribution layer structure 180.

In an example, the redistribution layer structure 180 comprises the electrically insulating layer structure 102, 140 and/or the electrically conductive layer structure 104 like the stack made of a build-up structure. In other words, a multilayer with an interior wiring structure. A redistribution structure may function as an electric interface between larger electrically conductive structures, as characteristic for a PCB on one side of the inorganic carrier, and smaller electrically conductive structures of a surface mounted component.

**Figure 2** illustrates a component carrier 100 comparable to that of Figure 1, according to an exemplary embodiment of the invention. Yet, the component carrier 100 of Figure 2 comprises the stop layer 130 configured as a discontinuous layer comprising at least two isolated stop layer portions 130a, 130b. The at least two stop layer portions 130a, 130b cover two or more edge portions 123 of the bottom 121 of the cavity 120. The stop layer 130 thus only covers the edge portions of the cavity 120 (here shown as left and right side). In between the stop layer portions 130a, 130b, the component 150 (specifically the adhesive layer 151, is in direct contact with the inorganic layer structure 110. Further, in this example, the stop layer 130 is configured as a multi-layer, comprising here two (or more) layers.

**Figure 4** shows a detail of a component carrier 100, according to an exemplary embodiment of the invention. The inorganic layer structure 110 comprises a recess 116 in the main surface 111. On top of the inorganic layer structure 110 and in the recess 116, there is arranged a stop layer 130. In this example, the recess 116 has a height of 10 µm, while the projected distance of the slope of the sidewall is around 30 µm. In this embodiment, the stop layer 130 can also cover (at least part) of the main surface 111 of the inorganic layer structure 110.

**Figure 6A** depicts a detail of a component carrier 100, according to an exemplary embodiment. An inorganic layer structure 110 has a recess 116 in the main surface 111 and the cavity 120 is formed in the electrically insulating layer 140. As can be seen, the cavity 120 comprises the recess 116. A stop layer 130 is arranged at least partially the main surface 111 of the inorganic layer structure 110 (the recess 116). A first sidewall portion 122a of the electrically insulating layer 140 and a third sidewall portion 122b of the recess 116 have a different slope, in particular inclined and straight, with respect to the thickness direction (along z). In other words, the first sidewall portion 122a is slightly offset with respect to the third sidewall portion 122b (in the direction away from the recess 116). The recess 116 is filled by a continuous stop layer 130. In this example, the stop layer 130 only partially fills the recess 116 in the vertical direction. While in one portion, the stop layer 130 with a protrusion from the stop layer surface is flush with the main surface 111 of the inorganic layer structure 110, in another portion, the stop layer 130 is not flush, in particular lower, than said main surface 111. The stop layer 130 also comprises an inclined sidewall in this example.

**Figure 6B** depicts a detail of a component carrier 100, according to an exemplary embodiment. This example is comparable to the one of Figure 6A, yet, the first sidewall portion 122a is offset towards the recess 116 and has the same inclination as a second sidewall portion 122c of the stop layer 130. Therefore, the first sidewall portion 122a and the second sidewall portion 122c together form a continuous sidewall, thus first sidewall portion 122a and the second sidewall portion are aligned. The electrically insulating layer 140 (and the first sidewall portion 122a) overlap/cover the inorganic layer structure 110. The stop layer 130 is in this example in direct contact with the electrically insulating layer structure 140, in particular the first sidewall portion 122a of the insulting layer structure Is in direct contact with the second sidewall portion 122c.

**Figure 7** depicts a detail of a component carrier 100, according to another exemplary embodiment. The stop layer 130 is configured in a discontinuous manner (compare Figure 2). The component 150 is higher (thicker) than the cavity 120 and material of the encapsulation layer structure 160 fills the space between the sidewall of the electrically insulating layer 140, the sidewall (and the top) of the component 150, and the top of the stop layer 130 (and the sidewall of the adhesive layer 151). On top of the component 150, there is arranged an electric pad/via connection 182 (compare Figure 2).

**Figure 8** shows a further detail of a component carrier 100, according to another exemplary embodiment. The example is comparable to the one of Figure 6B, yet, there is formed a recessed portion 125 in the electrically insulating layer 140 (first sidewall portion 122a) on top of the stop layer 130 and the main surface 111. At least a part of the recessed portion 125 is arranged in parallel to the bottom of the cavity. In a further example (not shown), the recessed portion 125 is at least partially filled with material of the encapsulation layer structure. In this example, the main surface 111 and the upper surface of the stop layer 130 are flush. Further, the recessed portion 125 extends along the main surface 111 in a direction perpendicular to thickness direction (along z).

**Figure 9** shows the stop layer 130 at the bottom 121 of the cavity 120 and in the recess 116 within the inorganic layer structure 110, according to an exemplary embodiment of the invention. In this example, the stop layer 130 has a cross-section with an upper part being wider than a lower part. It can be further seen that the recess 116 has a tapering sidewall, while the sidewall of the cavity 120 in the electrically insulating layer structure 140 is straight. The lower edge of the sidewall at the electrically insulating layer structure 140 is aligned (flush) with the top edge of the recess 116 without shift.

**Figure 10A** shows a top view of the component carrier 100 with a continuous stop layer 130 covering the whole side portions and edge portions 123 at the bottom 121 of the cavity 120. The covered edge portions 123 thereby form a stop layer frame 135.

**Figure 10B** shows a top view of the component carrier 100 with a discontinuous stop layer 130 comprising at least two isolated stop layer portions 130a and 130b that respectively cover opposed side portions 123 in the cavity 120.

**Figure 10C** shows a top view of the component carrier 100 with a continuous stop layer 130 covering the whole bottom 121 of the cavity 120. Thus, the full pattern as stop layer provides a large tolerance for cavity formation during manufacturing. It allows for a larger window and easy control for manufacturing process.

**Figure 11A** shows a top view of the component carrier 100 with a discontinuous stop layer 130 comprising four isolated stop layer portions 130a, 130b, one in each edge portion 124 (one in each corner).

**Figure 11B** shows a top view of the component carrier 100 with a discontinuous stop layer 130 comprising multiple isolated stop layer portions 130a and 130b distributed over the bottom 121 of the cavity 120.

**Figures 12A to 12L** illustrate a process of manufacturing a component carrier 100 with a continuous stop layer 130, according to an exemplary embodiment of the invention.
Figure 12A: an inorganic layer structure 110 with a main surface 111 is provided.
Figure 12B: through-holes 105 (through-glass vias) are formed in the inorganic layer structure 110, in particular by laser drilling inducing the inorganic layer structure 110 (preferably made of glass) to modify the material property and change the bonding chain of the material; then it can be formed as a through hole at the laser induced area by etching away the material from above and from below.
Figure 12C: a protective film 145, which may be a photosensitive material, is provided on top and bottom of the inorganic layer structure 110. An opening in the protective film 145 is provided for forming the recess 116 by exposure or etching or laser.
Figure 12D: the recess 116 is formed in the main surface 111, not covered by the protective film 145, e.g. by laser to induce the material for material property change and then etching away the material. The bottom wall and sidewalls of the recess 116 may have a roughness which is different from the main surface due to the laser inducing treatment and etching.
Figure 12E: the protective film 145 has been removed (stripped).
Figure 12F: the through-holes 105, the main surfaces of the inorganic layer structure 110, and the recess 116 are filled/covered by sputtering or eless plating a seed layer and/or a barrier layer on the inner surface of through hole and recess and external surface of the inorganic layer structure and then following plating with metal, e.g. copper and/or other metal. Thereby, through-glass vias 115 and electrically conductive material layers 136 are formed.
Figure 12G: the electrically conductive material layers 136 are respectively removed, e.g. by grinding, to leave only the stop layer 130 in the recess 116.
Figure 12H: an electrically insulating layer 140 is formed (laminated) on top of the inorganic layer structure 110. The electrically insulating layer may be a liquid material coated on the inorganic layer structure 110. The electrically insulating layer can be ABF or another resin or photosensitive dielectric material.
Figure 121: Vias 104 are formed through the electrically insulating layer 140.
Figure 12J: a cavity 120 is formed in the electrically insulating layer 140, e.g. by laser or exposure or etching, thereby exposing the stop layer 130 at the bottom of the cavity 120. There may be an undercut formed between the stop layer 130 and the electrically insulating layer 140. Further, a different roughness on the stop layer 130 edge area may be provided by laser drilling, ablating the stop layer 130 where the light reaches. The reflection of laser light may also ablate the surface of the sidewall of electrically insulating layer structure 140; which means the roughness of the cavity sidewall in the electrically insulating layer structure 140 can be different from the surface of the electrically insulating layer structure 140. If the electrically conductive layer 104 is formed by photosensitive dielectric material, the cavity 120 can be formed by exposure, then there may be no undercut and different roughness of stop layer 130.
Figure 12K: a component 150 is placed in the cavity 120 and onto the stop layer 130 (die bonding).
Figure 12L: further build-up is done to provide a component carrier 100 as described for Figure 1.

**Figures 13A to 13L** illustrate a process of manufacturing a component carrier 100 with a discontinuous stop layer 130, according to an exemplary embodiment of the invention.
Figure 13A: same process steps as in 12A to 12G have been performed. Yet, instead of a continuous stop layer 130, isolated stop layer portions 130a, 130b have been formed in respective recesses in the main surface 111 of the inorganic layer structure 110.
Figure 13B: a temporary structure 146 (e.g. release ink print) is applied on the isolated stop layer portions 130a, 130b.
Figure 13C: the temporary structure 146 is trimmed (e.g. using laser).
Figure 13D: an electrically insulating layer 140 is formed (laminated) on top of the inorganic layer structure 110.
Figure 13E: vias 104 are formed through the electrically insulating layer 140.
Figure 13F: a cavity 120 is formed by first cutting into the electrically insulating layer 140,which may be formed as Fig. 12J.
Figure 13G: the cavity 120 is further formed by removing the portion of the electrically insulating layer 140 on top of the temporary structure 146.
Figure 13H: the cavity 120 is now provided with the stop layer portions 130a, 130b exposed at the bottom of the cavity 120.
Figure 13I: a component 150 is placed in the cavity 120 and onto the stop layer portions 130a, 130b (die bonding).
Figure 13J: the embedded component 150 is encapsulated in the cavity 120 by encapsulation material 160.
Figure 13K: further layer build-up using electric via connections 182 is performed.
Figure 13L: further build-up is done to provide a component carrier 100 as described for Figure 2.

### Reference signs

- 100: Component carrier
- 101: Stack
- 102: Electrically insulating layer structure
- 104: Electrically conductive layer structure
- 105: Hole
- 110: Inorganic layer structure
- 111: First main surface
- 112: Second main surface
- 115: Electric through-connection
- 116: Recess in inorganic layer structure, part of cavity
- 120: Cavity
- 121: Bottom of cavity
- 122: Sidewall of cavity
- 122a: First sidewall portion, insulting layer structure
- 122b: Third sidewall portion, inorganic layer structure
- 122c: Second sidewall portion, stop layer
- 123: Side portion
- 124: Edge portion
- 125: Recessed portion
- 126: Stepped portion
- 130: Stop layer
- 130a/b: Stop layer portions
- 135: Stop layer frame
- 136: Electrically conductive material
- 140: Electrically insulating layer
- 145: Protective film
- 146: Temporary structure
- 150: Component
- 151: Adhesive portion
- 160: Encapsulation material, encapsulation layer structure
- 170: External surface layer, solder resist/surface finish
- 180: Redistribution layer structure
- 181: Electric connection
- 182: Via connection

## Claims

1. A component carrier (100) having a stack (101), wherein the stack (101) comprises:
at least one electrically conductive layer structure (104) and at least one electrically insulating layer structure (102, 140);
an inorganic layer structure (110) with a, in particular planar, main surface (111);
a cavity (120) in the stack (101), defined by a bottom (121) and a sidewall (122); and
at least one stop layer (130), arranged at least partially in or on the main surface (111) of the inorganic layer structure (110) and exposed at the bottom (121) of the cavity (120).

2. The component carrier (100) according to claim 1,
wherein the stop layer (130) is embedded in a recess (116) of the inorganic layer structure (110),
in particular wherein the recess (116) comprises a height of 10 µm or less.

3. The component carrier (100) according to claim 1 or 2,
wherein the stop layer (130) is configured as a metal layer and/or an electrically conductive structure,
in particular a copper layer and/or a titanium layer.

4. The component carrier (100) according to any one of the preceding claims,
wherein the stop layer (130) is a single layer or a multiple layer,
in particular wherein the thickness of the single layer or one of the multiple layers is smaller than that of the electrically conductive layer structure (104) of the stack (101),
more in particular wherein the stop layer (130) is a seed layer.

5. The component carrier (100) according to any one of the preceding claims, wherein the stop layer (130) is a discontinuous layer.

6. The component carrier (100) according to any one of the preceding claims,
wherein the stop layer (130) comprises a protruding portion that defines a part of the cavity sidewall (122) and/or protrudes from a further, in particular planar, portion of the stop layer (130).

7. The component carrier (100) according to any one of the preceding claims, further comprising:
a component (150) arranged at least partially in the cavity (120) and at least partially on, in particular directly on, the stop layer (130),
in particular wherein the component (150) is at least partially encapsulated in electrically insulating material (102, 140, 160).

8. The component carrier (100) according to any one of the preceding claims, further comprising:
an electrically insulating layer (140), in particular an electrically insulating layer structure (102) of the stack (101), arranged on the inorganic layer structure (110), wherein the cavity (120) is at least partially formed in the electrically insulating layer (140),
in particular wherein the cavity (120) extends in the electrically insulating layer (140) above the main surface (111) of the inorganic layer structure (110).

9. The component carrier (100) according to any one of the preceding claims,
wherein the sidewall (122) is defined by one of: the electrically insulating layer (140) exclusively, by the electrically insulating layer (140) and the inorganic layer structure (110), by the electrically insulating layer (140), by the stop layer (130).

10. The component carrier (100) according to any one of the preceding claims,
wherein the cavity (120) comprises at least two sidewall portions (122a-c);
in particular
wherein a first sidewall portion (122a) is formed in the electrically insulating layer structure (102, 140); and/or
wherein a second sidewall portion (122c) is formed in the electrically conductive layer structure (104) or by the stop layer (130).

11. The component carrier (100) according to any one of the preceding claims,
wherein a third sidewall portion (122b) is formed by the inorganic layer structure (110);
in particular
wherein the first sidewall portion (122a) and/or the third sidewall portion (122b) is recessed by a recessed portion (125) with respect to a vertical direction (z); and/or
wherein the first sidewall portion (122a) and the second sidewall portion (122c) or the third sidewall portion (122b) have a different slope.

12. The component carrier (100) according to any one of the preceding claims,
wherein the height of the sidewall (122) of the cavity (120), in particular the recess (116) in the inorganic layer structure (110), is larger than the thickness of the electrically conductive layer structure (104) of the stack (101), in particular in the range 0.5 to 2 times larger; and/or
wherein the height of the sidewall (122) of the cavity (120), in particular the recess (116) in the inorganic layer structure (110), is 10 µm or less.

13. The component carrier (100) according to any one of the preceding claims,
wherein a sidewall of the recess (116) in the inorganic layer structure (110) comprises a slope width of 30 µm or less, in particular 25 µm or less; and/or
wherein the sidewall of the recess (116) in the inorganic layer structure (110) is essentially straight.

14. The component carrier (100) according to any one of the preceding claims, further comprising:
a stepped region (126) at an interface of the electrically insulating layer (140) and the inorganic layer structure (110).

15. A method of manufacturing a component carrier (100), the method comprising:
providing an inorganic layer structure (110) with a main surface (111);
arranging at least one stop layer (130) at least partially in or on the main surface (111) of the inorganic layer structure (110);
forming an electrically insulating layer structure (102) and an electrically conductive layer structure (104) on said main surface (111) of the inorganic layer structure (110) to provide a stack (101); and
forming a cavity (120) in the stack (101), defined by a bottom (121) and a sidewall (122), wherein the stop layer (130) is arranged at the bottom (121) of the cavity (120).
